(19) Europäisches Patentamt / European Patent Office / Office européen des brevets

(11) **EP 4 657 701 A1**

(12) **EUROPEAN PATENT APPLICATION**
published in accordance with Art. 153(4) EPC

(43) Date of publication:
03.12.2025 Bulletin 2025/49

(21) Application number: 23918469.0

(22) Date of filing: 24.08.2023

(51) International Patent Classification (IPC):
*H02J 7/00* (2006.01)     *G01R 31/3828* (2019.01)
*G07F 17/00* (2006.01)     *H01M 10/48* (2006.01)

(52) Cooperative Patent Classification (CPC):
G01R 31/3828; G07F 17/00; H01M 10/48;
H02J 7/00

(86) International application number:
PCT/JP2023/030486

(87) International publication number:
WO 2024/157509 (02.08.2024 Gazette 2024/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 23.01.2023 JP 2023008177

(71) Applicant: **Panasonic Intellectual Property
Management Co., Ltd.**
**Kadoma-shi, Osaka 571-0057 (JP)**

(72) Inventor: **HORI, Kunihiko
Kadoma-shi, Osaka 571-0057 (JP)**

(74) Representative: **Novagraaf International SA
Chemin de l'Echo 3
1213 Onex, Geneva (CH)**

(54) **VEHICLE USAGE SITUATION ESTIMATION SYSTEM, VEHICLE USAGE SITUATION ESTIMATION METHOD, AND VEHICLE USAGE SITUATION ESTIMATION PROGRAM**

(57) In a vehicle usage status estimation system (10), a data acquisition unit acquires, while a battery pack (30) currently or previously mounted on an electric vehicle (40) is connected to a charging apparatus (20), time-series battery data covering a period during which the electric vehicle (40) is used from the battery pack (30) via the charging apparatus (20). An SOC transition identification unit identifies a transition of SOC (State Of Charge) of the battery pack (30) since completion of previous charging of the battery pack (30) used in the electric vehicle (40), based on the time-series battery data. A running status estimation unit estimates a running status at a time of use of the electric vehicle (40) by referring to the transition of SOC.

FIG. 1

**Description**

TECHNICAL FIELD

The present disclosure relates to a vehicle usage status estimation system, a vehicle usage status estimation method, and a vehicle usage status estimation program for estimating the usage status of an electric vehicle equipped with a battery pack.

BACKGROUND ART

In recent years, relatively small electric vehicles such as EVs, ultra-compact EVs, electric motorcycles, electric bicycles, and electric kick skaters have become popular. Electrification of delivery vehicles is also progressing. Since the mileage of electric vehicles is shorter than that of engine-powered vehicles, it is necessary to charge them frequently. In association with this, the rental service for charged battery packs is becoming popular. In the battery pack rental service, charging management according to the user's needs and a management method that minimizes deterioration of battery packs are called for. In addition, the rental service for small electric vehicles equipped with battery packs, rather than battery packs alone, are also becoming popular.

Patent Literature 1 exemplifies a related art that contributes to degradation control of a battery and discloses a method of calculating an energy-saving running evaluation index with reference to speed and mileage. Further, Patent Literature 2 exemplifies a related art that evaluates the residual value of a battery and discloses a method of acquiring information at the time of battery use from a vehicle, determining whether an abnormal usage record is found, and setting a trade-in price for the battery. Patent Literature 2 teaches acquiring vehicle information such as vehicle model, mileage, and acceleration/deceleration from a vehicle-mounted terminal in order to keep track of the running status of the vehicle. Therefore, the method disclosed in Patent Literature 2 can be applied only to vehicles equipped with a vehicle-mounted terminal capable of recording time-series vehicle information and externally outputting the recorded time-series vehicle information.

As described above, it is important to know the degree of degradation of a product in the rental service of battery packs or small electric vehicles. The degree of long-term degradation of a battery pack can be determined by SOH (State Of Health), but battery packs are generally rented for a short period of one day or less. In addition, degradation of a battery pack depends greatly on how it is used on a daily basis. Therefore, it is necessary to know the status of usage of the electric vehicle by the user.

RELATED-ART LITERATURE

PATENT LITERATURE

[Patent Literature 1] JP 2018-35677
Patent Literature 2: JP2021-51843

SUMMARY OF INVENTION

TECHNICAL PROBLEM

However, it is difficult to obtain vehicle data such as speed and mileage in an electric vehicle of a simple system, and it is difficult to know how the renting user handles the electric vehicle.

The present disclosure addresses the issue described above, and a purpose thereof is to provide a technology of estimating the status of usage of an electric vehicle by the user without using vehicle data.

SOLUTION TO PROBLEM

A vehicle usage status estimation system according to an embodiment of the present disclosure includes: a data acquisition unit that acquires, while a battery pack currently or previously mounted on an electric vehicle is connected to a charging apparatus, time-series battery data covering a period during which the electric vehicle is used from the battery pack via the charging apparatus; an SOC transition identification unit that identifies a transition of SOC (State Of Charge) of the battery pack since completion of previous charging of the battery pack used in the electric vehicle, based on the time-series battery data; and a running status estimation unit that estimates a running status at a time of use of the electric vehicle by referring to the transition of SOC.

Optional combinations of the aforementioned constituting elements, and implementations of the present disclosure in the form of apparatuses, systems, methods, and computer programs are also useful as embodiments of the present disclosure.

ADVANTAGEOUS EFFECTS OF INVENTION

According to the present disclosure, it is possible to estimate the status of usage of an electric vehicle by the user without using vehicle data.

BRIEF DESCRIPTION OF DRAWINGS

[Fig. 1] Fig. 1 shows an overview of a path of battery data input to a vehicle usage status estimation system according to the embodiment.
[Fig. 2] Fig. 2 shows an exemplary configuration of the battery pack.
[Fig. 3] Fig. 3 shows an exemplary configuration of the charging apparatus.
[Fig. 4] Fig. 4 shows an exemplary configuration of the vehicle usage status estimation system according to the embodiment.
[Fig. 5] Fig. 5 shows exemplary vehicle data during a single period of use of a given electric motorcycle.
[Fig. 6] Fig. 6 shows exemplary battery data for the battery pack mounted on the electric motorcycle corresponding to the vehicle data of Fig. 5.
[Fig. 7] Fig. 7 shows a specific example of the transition of the vehicle speed, SOC, SOC change amount, and estimated speed level, and the level of average amount of SOC change during a single period of use of a given electric motorcycle.
[Fig. 8] Fig. 8 shows a transition of the estimated speed level and SOC during a single period of use of a given electric motorcycle with reference to the actual time.
[Fig. 9] Fig. 9 shows a transition of the estimated speed level and SOC during a single period of use of a given electric motorcycle with reference to a distribution of the estimated mileage.
[Fig. 10] Fig. 10 is a flowchart showing an exemplary operation of the vehicle usage status estimation system according to the embodiment.

DESCRIPTION OF EMBODIMENTS

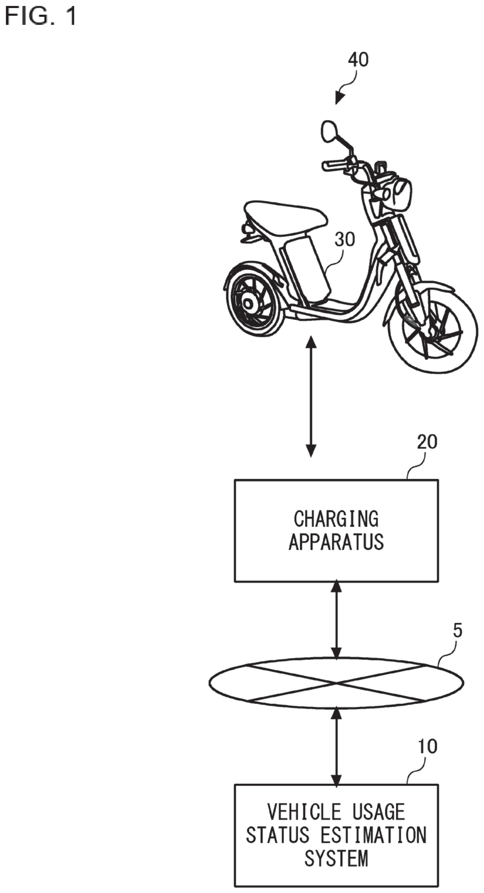

Fig. 1 shows an overview of a path of battery data input to a vehicle usage status estimation system 10 according to the embodiment. In the embodiment, an electric motorcycle 40 is assumed as an electric vehicle subject to vehicle usage status estimation. The electric motorcycle 40 includes a mounting slot for mounting a removable, portable and replaceable battery pack 30. The battery pack 30 can also be mounted on a charging slot of a charging apparatus 20. The battery pack 30 is charged while being mounted on the charging slot of the charging apparatus 20.

In the sharing service of the battery pack 30, the following operation is possible because it is not necessary to link the battery pack 30 with the electric motorcycle 40 one on one. The charged battery pack 30 is taken out of the charging slot by the user (usually the driver of the electric motorcycle 40) and mounted on the mounting slot of the electric motorcycle 40. The battery pack 30 mounted on the mounting slot of the electric motorcycle 40 is discharged while the electric motorcycle 40 is running, and the SOC decreases in association with the discharge. The battery pack 30 in which the SOC has decreased is taken out of the mounting slot of the electric motorcycle 40 by the user and mounted on the charging slot of the charging apparatus 20. The user takes out the charged battery pack 30 from a further charging slot of the charging apparatus 20 and mounts it on the mounting slot of the electric motorcycle 40. Through this series of operations, the battery pack 30 in which the SOC has decreased is replaced with the charged battery pack 30. Thereby, the user does not have to wait while the battery pack 30 is being charged and can resume running the electric motorcycle 40 in a short time.

The charging apparatus 20 acquires battery data from the battery pack 30 mounted on the charging slot and transmits the data to the vehicle usage status estimation system 10 via a network 5. For example, the vehicle usage status estimation system 10 may be constructed on an in-house server installed in in-house facilities or a data center of a business operator that provides a sharing service of the battery pack 30 or an analysis service of the battery pack 30. Alternatively, the vehicle usage status estimation system 10 may be constructed on a cloud server that is used based on a cloud service. Alternatively, the vehicle usage status estimation system 10 may be constructed on a plurality of servers distributed across a plurality of sites (data centers, in-house facilities). The plurality of servers may be any of a combination of a plurality of in-house servers, a combination of a plurality of cloud servers, or a combination of in-house servers and cloud servers. When only a small number of battery packs 30 are managed, the vehicle usage status estimation system 10 may be constructed on a PC, tablet, or smartphone rather than on a server.

The network 5 is a general term for a communication channel such as the Internet, leased lines, and VPN (Virtual Private Network), and the communication medium or protocol does not matter. For example, a mobile phone network, wireless LAN, wired LAN, optical fiber network, ADSL network, CATV network, etc. can be used as the communication medium. For example, TCP (Transmission Control Protocol)/IP (Internet Protocol), UDP (User Datagram Protocol)/IP, Ethernet (registered trademark), etc. can be used as the communication protocol.

A system configuration in which the vehicle usage status estimation system 10 is built in the charging apparatus 20 is also possible. In that case, the network 5 is replaced by serial communication in the charging apparatus 20.

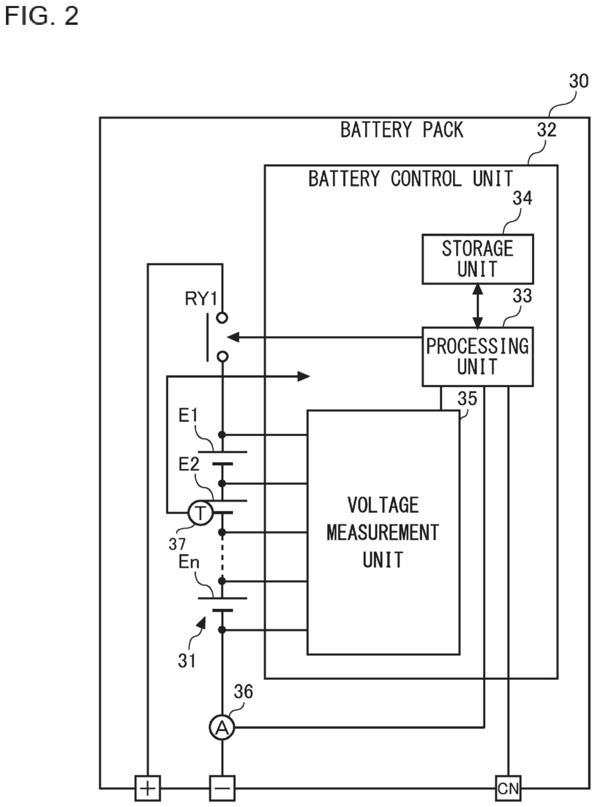

Fig. 2 shows an exemplary configuration of the battery pack 30. The battery pack 30 includes a battery assembly 31 and a battery control unit 32 as main components. The battery control unit 32 includes a processing unit 33, a storage unit 34, and a voltage measurement unit 35. The processing unit 33 can be configured with a microcontroller. The storage unit 34 can be configured with a non-volatile memory (e.g., EEPROM (Electrically Erasable Programmable Read-Only Memory) or flash memory).

The battery assembly 31 is connected between the positive terminal and the negative terminal of the battery pack 30. The battery assembly 31 includes a plurality of cells E1-En connected in series. The battery assembly 31 may be configured with a series arrangement of a plurality of cell blocks, in each of which a plurality of cells are connected in parallel. A lithium ion battery cell, a nickel-hydrogen battery cell, a lead battery cell, etc. can be used as the cell. Hereinafter, an example of using a lithium ion battery cell (nominal voltage: 3.6-3.7 V) is assumed hereinafter. The number of cells E1-En in the series is determined according to the drive voltage of the running motor of the electric motorcycle 40.

A relay RY1 is connected on the power line between the positive terminal of the battery pack 30 and the positive electrode of the battery assembly 31. The relay RY1 may be connected to the negative electrode. A current sensor 36 is provided on the power line between the negative terminal of the battery pack 30 and the negative electrode of the battery assembly 31. The current sensor 36 may be provided on the positive electrode. The current sensor 36 measures the current flowing through the battery assembly 31 and outputs the measured current value to the processing unit 33 of the battery control unit 32. The current sensor 36 can be configured with, for example, a combination of a shunt resistor, a differential amplifier, and an A/D converter. A Hall element may be used instead of a shunt resistor.

A plurality of voltage measurement lines are connected between the voltage measurement unit 35 and the respective nodes of the plurality of cells E1-En connected in series. The voltage measurement unit 35 measures the voltage of each cell E1-En by measuring the voltage between two adjacent voltage measurement lines. The voltage measurement unit 35 transmits the measured voltage value of each cell E1-En to the processing unit 33.

Since the voltage measurement unit 35 is at a higher voltage with respect to the processing unit 33, the voltage measurement unit 35 and the processing unit 33 are connected by a communication line in an insulated state. The voltage measurement unit 35 can be configured with an ASIC (Application Specific Integrated Circuit) or a general-purpose analog front-end IC. The voltage measurement unit 35 includes a multiplexer and an A/D converter. The multiplexer outputs the voltage between two adjacent voltage measurement lines to the A/D converter in the order from top. The A/D converter converts the analog voltage input from the multiplexer into a digital value.

A temperature sensor 37 is provided in the battery assembly 31. The temperature sensor 37 measures the temperature of the battery assembly 31 and outputs the measured temperature value to the processing unit 33. The temperature sensor 37 can be configured with, for example, a combination of a thermistor, a voltage division resistor, and an A/D converter. The temperature sensor 37 may be provided at a plurality of locations of the battery assembly 31.

The processing unit 33 estimates the SOC of each cell E1-En by combining the OCV (Open Circuit Voltage) method and the current accumulation method. The OCV method is a method of estimating the SOC based on the OCV of the measured cell and the SOC-OCV curve of the cell. The SOC-OCV curve of the cell is prepared in advance based on a characteristic test by the battery manufacturer and registered in the processing unit 33 at the time of shipment.

The current accumulation method is a method of estimating the SOC based on the OCV at the start of charging or discharging of the cell and the integrated value of the measured current. In the current accumulation method, the current measurement error accumulates as the charging or discharging time increases. Therefore, it is preferable to use a weighted average of the SOC estimated by the current accumulation method and the SOC estimated by the OCV method.

The processing unit 33 is adapted to convert the SOC of each cell E1-En into the actual capacity, synthesize the actual capacity to calculate the actual capacity of the battery pack 30, and estimate the SOC of the battery pack 30 based on the actual capacity and the current full charge capacity of the battery pack 30.

The processing unit 33 periodically (e.g., at 10-second intervals, at 1-minute intervals) samples the voltage of each cell E1-En constituting the battery assembly 31, the current flowing through the battery assembly 31, the temperature of the battery assembly 31, and the SOC of the battery assembly 31 and stores them in the storage unit 34 as battery data.

The positive terminal and the negative terminal of the battery pack 30 are connected to the power line of the electric motorcycle 40, and the control terminal CN thereof is connected to the signal line of the electric motorcycle 40 while the battery pack 30 is mounted on the mounting slot of the electric motorcycle 40. In that state, the processing unit 33 can supply power from the battery assembly 31 to the inverter of the electric motorcycle 40 by turning on the relay RY1.

The inverter converts the DC power supplied from the battery pack 30 into an AC power and supplies the power to the running motor. The running motor (e.g., a three-phase AC motor) rotates according to the AC power supplied from the inverter. Further, the battery pack 30 can supply power to various auxiliary gears (lights, blinkers, etc.) and control circuits (ECU (Electronic Control Unit), etc.) of the electric motorcycle 40.

The processing unit 33 of the battery pack 30 can exchange a control signal with the ECU of the electric motorcycle 40 via the control terminal CN while being mounted on the mounting slot of the electric motorcycle 40. For example, the processing unit 33 of the battery pack 30 can receive a power-on signal or a power-off signal from the ECU of the electric motorcycle 40. In the embodiment, it is assumed that vehicle data such as speed, mileage, and torque cannot be received from the ECU.

The positive terminal and the negative terminal of the battery pack 30 are connected to the power line of the charging apparatus 20, and the control terminal CN thereof is connected to the signal line of the charging apparatus 20 while the battery pack 30 is mounted on the mounting slot of the charging apparatus 20. In that state, the processing unit 33 can charge the battery assembly 31 from the charging apparatus 20 by turning on the relay RY1.

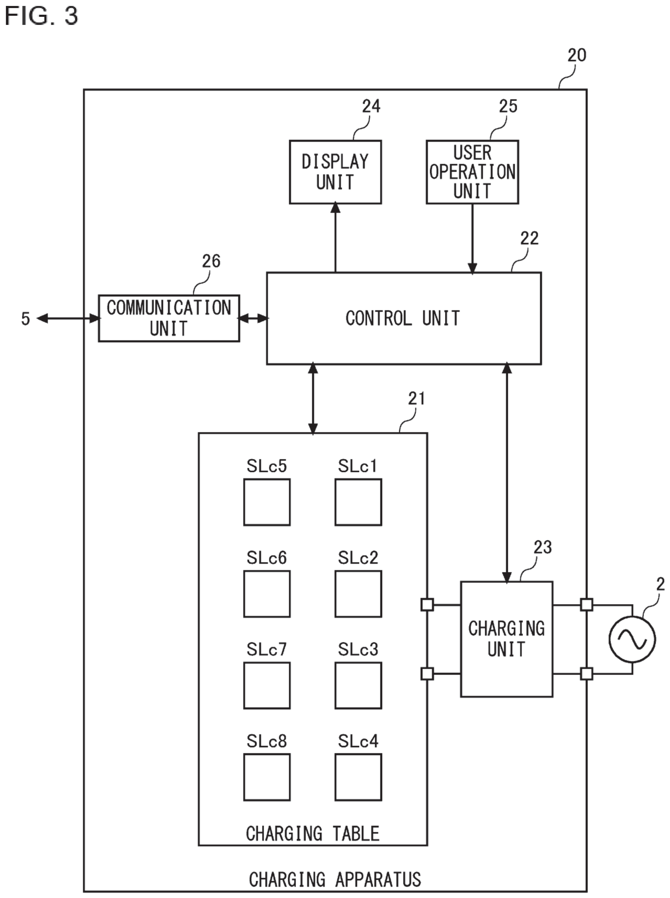

The processing unit 33 of the battery pack 30 can exchange a control signal with the control unit 22 of the charging apparatus 20 (see Fig. 3 described later) via the control terminal CN while being mounted on the charging slot. For example, the processing unit 33 of the battery pack 30 can read the battery data stored in the storage unit 34 and transmit the read battery data to the control unit 22 of the charging apparatus 20.

Fig. 3 shows an exemplary configuration of the charging apparatus 20. The charging apparatus 20 includes a charging table 21, a control unit 22, a charging unit 23, a display unit 24, a user operation unit 25, and a communication unit 26. The charging table 21 has a plurality of charging slots SLc1-SLc8 for mounting a plurality of battery packs 30. In the example shown in Fig. 3, the number of charging slots is 8, but the number of charging slots is arbitrary.

Each charging slot SLc1-SLc8 has connectors including a positive terminal, a negative terminal, and a control terminal. When the battery pack 30 is mounted, electric conduction is established between the charging slots and each of the positive terminal, negative terminal, and control terminal CN included in the connector of the battery pack 30.

The positive terminal and the negative terminal of each charging slot SLc1-SLc8 are connected to the positive terminal and the negative terminal of the charging unit 23, respectively. The charging unit 23 is connected to a commercial power system 2 and can charge the battery pack 30 mounted on the charging table 21. The charging unit 23 generates DC power by subjecting the AC power supplied from the commercial power system 2 to full-wave rectification and smoothing the rectified power with a filter.

A relay (not shown) is provided between the positive terminal and the negative terminal of the charging unit 23 and the positive terminal and the negative terminal of each charging slot SLc1-SLc8, respectively. The control unit 22 controls the conduction/non-conduction of each charging slot SLc1-SLc8 by controlling the on/off of each relay.

A DC/DC converter (not shown) may be provided between the positive and negative terminals of the charging unit 23 and the positive and negative terminals of each charging slot SLc1-SLc8, respectively. In that case, the control unit 22 can individually control the charging voltage or charging current of each battery pack 30 by controlling each DC/DC converter. The DC/DC converter may be provided in the battery pack 30. When an AC/DC converter is mounted in the battery pack 30, the battery pack 30 can be charged with the AC power from the charging unit 23.

The control unit 22 can be configured with a microcontroller. The control unit 22 acquires battery data from the battery pack 30 mounted on the charging table 21 via a signal line. The control unit 22 transmits the acquired battery data to the vehicle usage status estimation system 10 via the network 5. The communication unit 26 executes a communication signal process for connecting to the network 5.

The display unit 24 includes a display and displays guidance for the user who uses the charging apparatus 20 (usually, the driver of the electric motorcycle 40) on the display. The user operation unit 25 is a user interface such as a touch panel and accepts a user operation of the user. The charging apparatus 20 may further include a speaker (not shown) and output voice guidance from the speaker to the user.

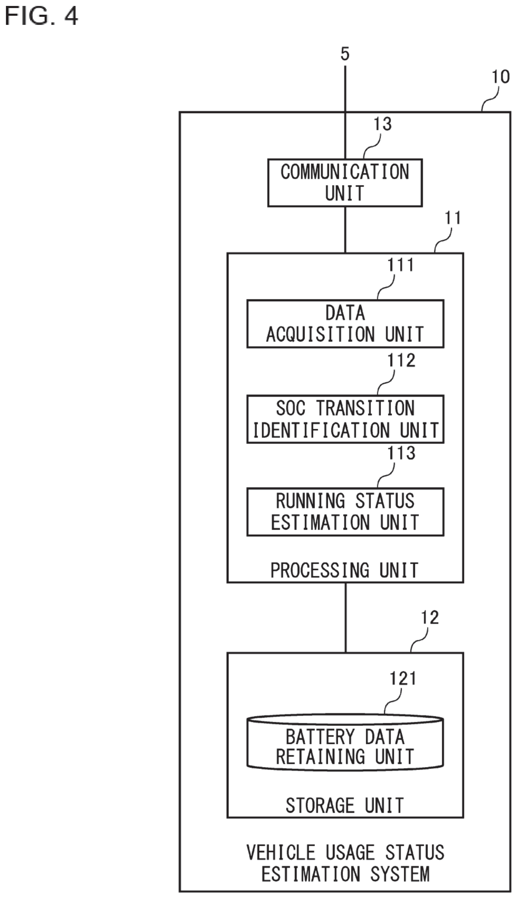

Fig. 4 shows an exemplary configuration of the vehicle usage status estimation system 10 according to the embodiment. The vehicle usage status estimation system 10 includes a control unit 11, a storage unit 12, and a communication unit 13. The communication unit 13 is a communication interface (e.g., a NIC: Network Interface Card) for connecting to the network 5 by wire or wirelessly.

The control unit 11 includes a data acquisition unit 111, a SOC transition identification unit 112, and a running status estimation unit 113. The function of the control unit 11 can be realized by cooperation between hardware resources and software resources or by hardware resources alone. CPU, ROM, RAM, GPU (Graphics Processing Unit), ASIC (Application Specific Integrated Circuit), FPGA (Field Programmable Gate Array), and other LSIs can be used as hardware resources. Programs such as operating systems and applications can be used as software resources. The storage unit 12 includes a non-volatile recording medium such as HDD or SSD and stores various data. The storage unit 12 includes a battery data retaining unit 121.

The data acquisition unit 111 acquires time-series battery data, covering the period during which the electric motorcycle 40 on which the battery pack 30 was mounted was previously used, from the battery pack 30 via the charging apparatus 20, while the battery pack 30 is connected to the charging apparatus 20. The data acquisition unit 111 stores the acquired time-series battery data in the battery data retaining unit 121.

When estimating the status of usage by the user of the electric motorcycle 40 on which the battery pack 30 was mounted, the SOC transition identification unit 112 reads the time-series battery data for the target battery pack 30 from the battery data retaining unit 121. Based on the time-series battery data thus read, the SOC transition identification unit 112 identifies the SOC transition during the power-on period of the electric motorcycle 40 powered from the battery pack 30. The running status estimation unit 113 estimates the running status at the time of use of the electric motorcycle 40 by the user by referring to the SOC transition.

As described above, the embodiment assumes that vehicle data such as speed, mileage, and torque cannot be acquired. Further, it assumed the inability to identify the model and model number of the electric motorcycle 40 on which the battery pack 30 was mounted.

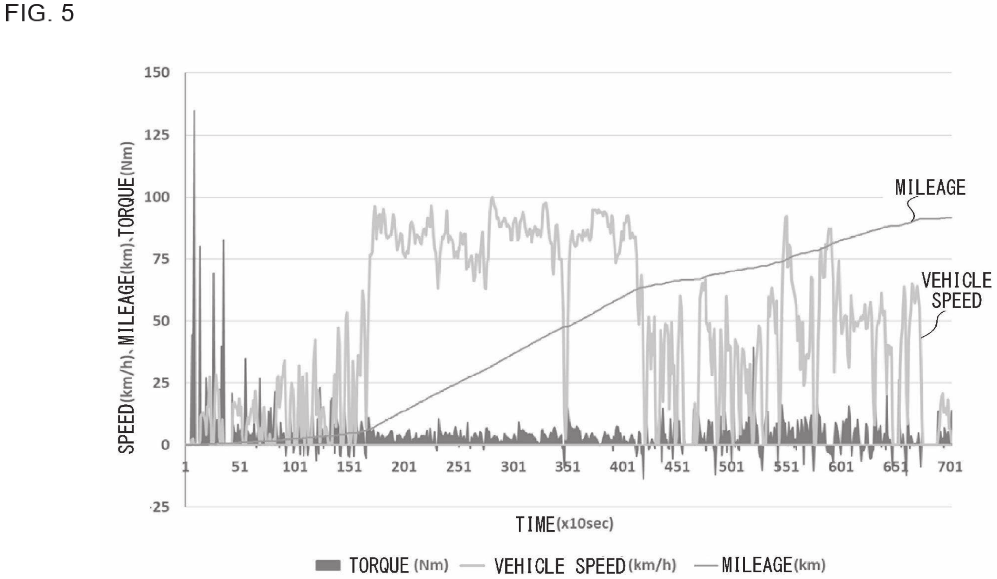

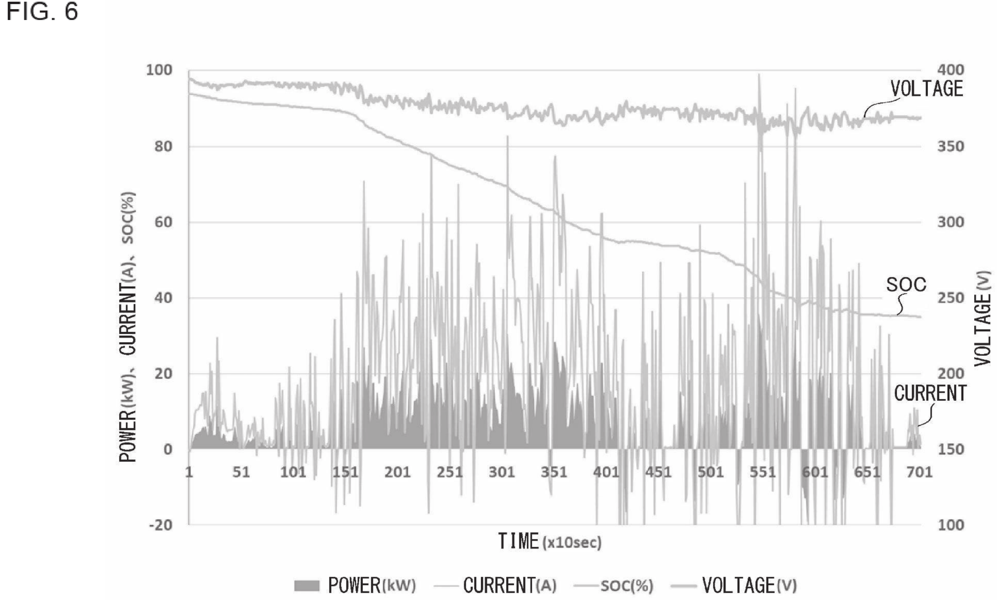

Fig. 5 shows exemplary vehicle data during a single period of use of a given electric motorcycle 40. Fig. 6 shows exemplary battery data for the battery pack 30 mounted on the electric motorcycle 40 corresponding to the vehicle data of Fig. 5. The vehicle data shown in Fig. 5 includes speed (km/h), mileage (km), and torque (Nm). The battery data shown in Fig. 6 includes power (kW), current (A), voltage (V), and SOC (%). Each data item is a 10-second sample, and Figs. 5 and 6 show data for about 2 hours. As shown in Figs. 5 and 6, the correlation between the data transition included in the vehicle data and the data transition included in the battery data is not necessarily high. An attempt for direct estimation of the running status of the electric motorcycle 40 from the power, current, voltage or SOC will result in a low accuracy of estimation of the running condition.

In the embodiment, therefore, the running status estimation unit 113 estimates the energy consumed by the electric motorcycle 40 from the amount of SOC change at each point of time of sampling and calculates the estimated speed level X(t) at each point of time of sampling based on the estimated energy consumption. The estimated speed level is a value representing a measure of the vehicle speed of the electric motorcycle 40 and does not indicate the actual vehicle speed. The estimated speed level can represent a relative change in vehicle speed by being arranged in a time series.

In the embodiment, SOC data for the battery pack 30 is used, and data for the current and power of the battery pack 30 is not used. Since the current and power are instantaneous values, the values fluctuate greatly depending on the sampling timing. On the other hand, the SOC is an integrated value and so is less affected by a gap in the sampling timing or noise. Further, the current and power are absolute values, but the SOC is a percentage value so that the impact from the size of the running motor of the electric motorcycle 40 mounted is eliminated.

In the embodiment, a smoothed value may be used for SOC(t) at each point of time of sampling. For example, a moving average value of SOC for the past 1 minute (6 SOC samplings) may be used for SOC(t) at each point of time of sampling. Smoothing reduces the influence of noise.

In the embodiment, the amount of SOC change ($\Delta$SOC (%)) of the battery pack 30 per unit time is defined by (expression 1) below.

$$\Delta SOC(t) = SOC(t) - SOC(t-1) \; \dots \; (expression\ 1)$$

where t denotes the point of time of sampling, and the amount of SOC change per unit time is defined by a difference between SOC(t) at a given point of time of sampling and SOC(t-1) at a point of time of sampling one unit time before. In the examples shown in Figs. 5 and 6, the unit time is 10 seconds.

In the embodiment, the average amount of SOC change ($\Delta$SOCave (%)) of the battery pack 30 during the period in which the electric motorcycle 40 is powered on is defined by (expression 2) below.

$$\Delta SOCave = (SOC\ at\ power - SOC\ at\ power\text{-}off) / power\text{-}on\ duration \; \dots$$

$$(expression\ 2)$$

...

For the power-on duration, a value normalized by the unit time is used. In the examples shown in Figs. 5 and 6, 10-second normalized values are used.

The energy consumed by the electric motorcycle 40 is classified into running energy used for the rotational energy of the running motor and non-running energy used for an end other than the rotational energy of the running motor. The running energy increases in proportion to the speed. The non-running energy is energy consumed even when the electric motorcycle 40 is at a stop and is defined by the sum of the energy consumed by the auxiliary gear and control circuit of the electric motorcycle 40, the energy consumed by the control circuit of the battery pack 30, and the self-discharge energy.

In the embodiment, the amount of SOC change per unit time ($\Delta$SOC' (%)) used for the running energy is defined by (expression 3) below.

$$\Delta SOC'(t) = \Delta SOC(t) - (\Delta SOCave/m) - (n * \Delta SOCave * X(t-1)) \ \dots \ (expression\ 3)$$

...

($\Delta$SOCave/m) indicates an expected value of the amount of SOC change per unit time used for the non-running energy (hereinafter referred to as the amount of non-running SOC change). In the embodiment, the expected value of the amount of non-running SOC change is defined by the value obtained by dividing the average amount of SOC change ($\Delta$SOCave) by a constant m. Further, when a period of time in which the amount of change is equal to or less than the average amount of SOC change and the fluctuation range of voltage and current is small can be extracted, that period is regarded as a stop period, and the amount of SOC change at that time is defined as the amount of non-running SOC change.

($n * \Delta$SOCave*X(t-1)) indicates an expected value of the amount of SOC change used for the running energy since a point of time one unit before in the case it is assumed that the estimated speed level X(t-1) of the electric motorcycle 40 at a point of time one unit before is maintained. Hereinafter, the amount of SOC change used for the running energy is referred to as an amount of running SOC change.

In the embodiment, an expected value of the amount of running SOC change in the case it is assumed that the estimated speed level X(t-1) at a point of time one unit before is maintained is defined by a value obtained by multiplying the average amount of SOC change ($\Delta$SOCave) by the estimated speed level X(t-1) at the point of time one unit before and a constant n. $X(t-1)^2$ may be used instead of X(t-1).

The estimated speed level X(t) at the target point of time may have increased (accelerated), have decreased (decelerated), or is maintained in comparison with the estimated speed level X(t-1) at the point of time one unit before.

In the embodiment, the estimated speed level X(t) ($\Delta$SOC' (t)$\geq$0) at the target point time in the case the speed has accelerated or is maintained at the same speed is defined by (expression 4) below. Further, the estimated speed level X(t) ($\Delta$SOC' (t)<0) at the target point of time in the case the speed has decelerated is defined by (expression 5) below.

$$X(t) = X(t-1) + (k/(X(t-1)2)) * \Delta SOC'(t) \ \dots \ (expression\ 4)$$

$$X(t) = X(t-1) + (l/(X(t-1)2)) * \Delta SOC'(t) \ \dots \ (expression\ 5)$$

As shown in (expression 4) and (expression 5), a speed change from the estimated speed level X(t-1) at the point of time one unit before is estimated by assuming a load component inversely proportional to the square of the speed and multiplying the load component by the amount of running SOC change ($\Delta$SOC'). The estimated speed level X(t) at the target point of time is calculated by adding the speed change to the estimated speed level X(t-1) at the point of time one unit before.

The constants m, n, k, l can be set by the designer based on the result of experiments or simulations or the designer's knowledge. It will be noted that an energy consumption model of a vehicle can be constructed from the vehicle weight, air resistance, road surface resistance, conversion efficiency of the running motor, etc. included in the vehicle specification information in the case the model and model number of the electric motorcycle 40 equipped with the battery pack 30 are known, and the vehicle specification information on the electric motorcycle 40 can be acquired in advance, In that case, highly precise constants m, n, k, and l can be derived based on the energy consumption model and the specification information (capacity, etc.) of the battery pack 30 used. In the case highly precise constants m, n, k, and l can be derived, it is also possible to calculate the estimated speed level as the actual speed (km/h).

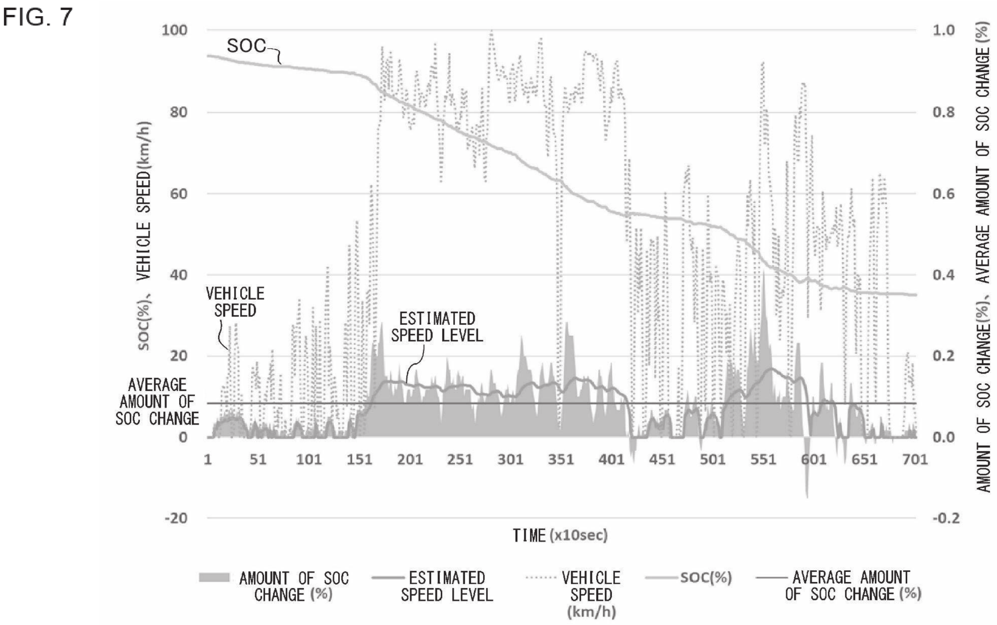

Fig. 7 shows a specific example of the transition of the vehicle speed, SOC, SOC change amount, and estimated speed level, and the level of average amount of SOC change during a single period of use of a given electric motorcycle 40. The vehicle speed (km/h) and SOC (%) are actual measured values, and the amount of SOC change (%), average amount of SOC change (%), and estimated speed level are values calculated based on the (expression 1)-(expression 5) above.

Referring to Fig. 7, it can be confirmed that there is a high correlation between the amount of SOC change (%) and the estimated speed level. Furthermore, it can be confirmed that the calculated estimated speed level can predict the transition of the actual vehicle speed (km/h).

For evaluation of the status of usage of the electric motorcycle 40 by the user, the running status estimation unit 113 can calculate at least one of the ratio between the running period and the stop period, frequency of starting/stopping, or proportion of the constant speed running period during the period of use of the electric motorcycle 40, based on the transition of the estimated speed level as calculated. For example, the running status estimation unit 113 sets a period during which the estimated speed level is accommodated within a predetermined range as a constant speed running period. The running status estimation unit 113 can correct the predicted transition of SOH of the battery pack 30 by referring to at least one of the frequency of starting/stopping or the proportion of the constant speed running period. For example, the running status estimation unit 113 corrects the degradation rate such that the larger the frequency of starting/stopping or the smaller the proportion of the constant speed running period, the greater the increase in the degradation rate. Conversely, the running status estimation unit 113 corrects the degradation rate such that the smaller the frequency of starting/stopping or the larger the proportion of the constant speed running period, the greater the reduction in the degradation rate.

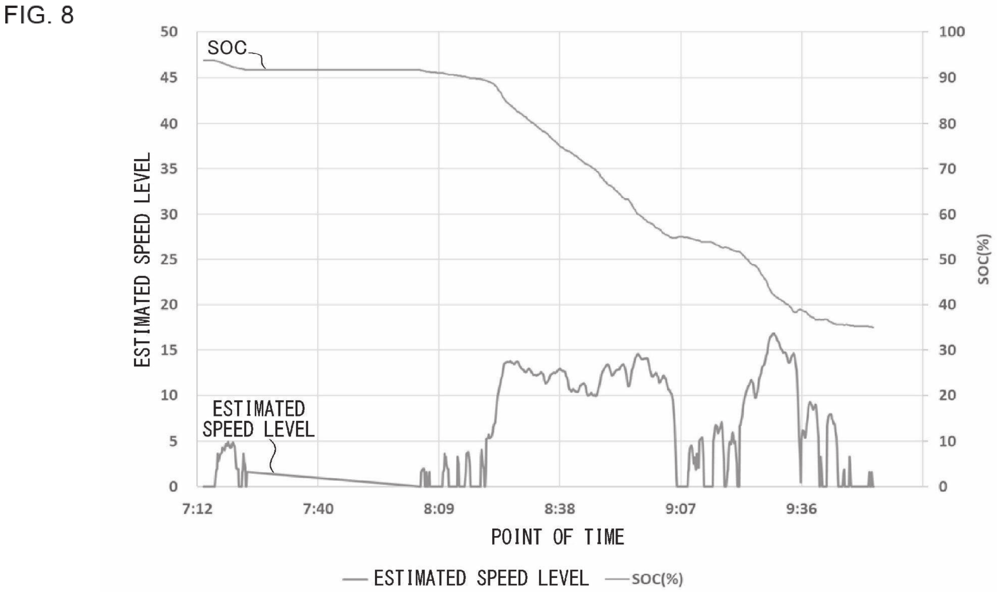

Fig. 8 shows a transition of the estimated speed level and SOC during a single period of use of a given electric motorcycle 40 with reference to the actual time. Normally, a time stamp is appended to each record of battery data so that it is possible to generate a transition of the estimated speed level with reference to the actual time.

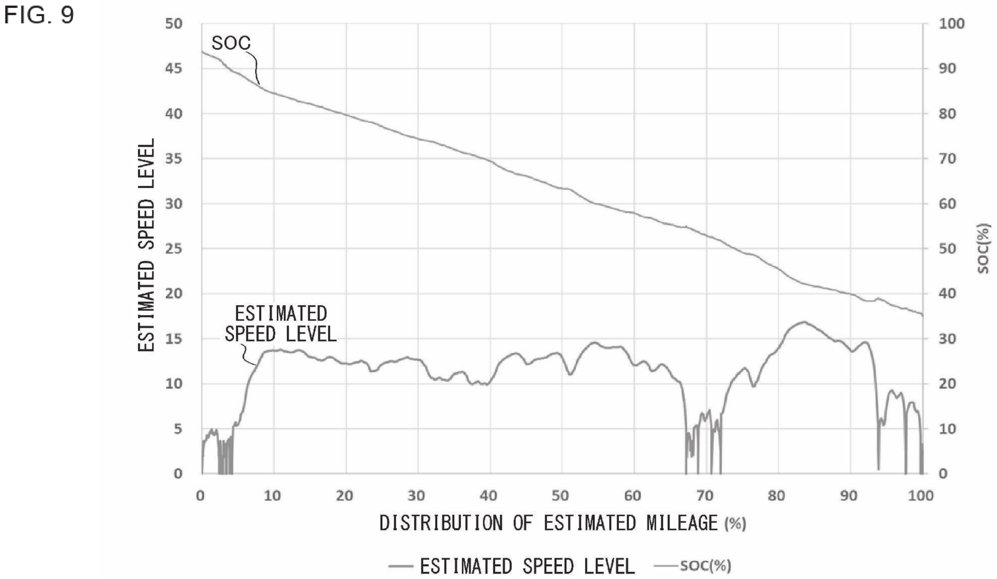

Fig. 9 shows a transition of the estimated speed level and SOC during a single period of use of a given electric motorcycle 40 with reference to a distribution of the estimated mileage. The estimated mileage shown in Fig. 9 is determined by defining the value derived from integrating the estimated speed level X(t) at each point of time of sampling during a single period of use of the electric motorcycle 40 to be 100. In the case the estimated speed level is calculated as the actual speed (km/h), the estimated mileage during a single period of use can be obtained as the actual distance.

The manager of the electric motorcycle 40 can visually check the mileage during a single period of use shown on the trip meter provided in the electric motorcycle 40 and input the confirmed mileage in the vehicle usage status estimation system 10. In this case, the running status estimation unit 113 can estimate the actual speed (km/h) at each point of time of sampling by back calculation based on the estimated speed level X(t) and the actual mileage at each point of time of sampling.

The running status estimation unit 113 can estimate the estimated speed level X(t) at each point of time or at each position of running during a single period of use. The sharing service provider of the battery pack 30 or the electric motorcycle 40 can estimate the general behaviour of the users from these data. For example, it is also possible to identify a time zone in which a lot of users are taking a break.

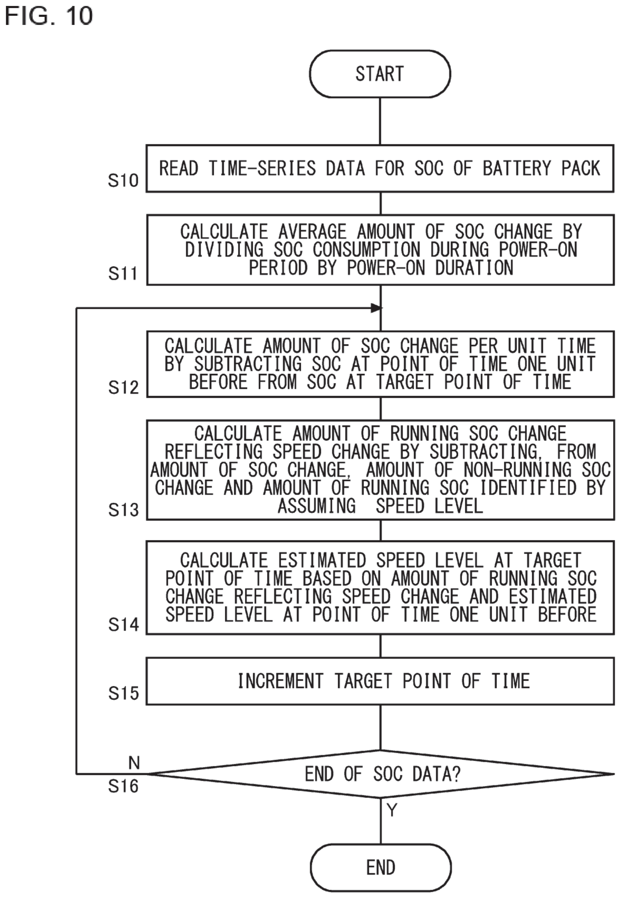

Fig. 10 is a flowchart showing an exemplary operation of the vehicle usage status estimation system 10 according to the embodiment. The SOC transition identification unit 112 reads time series data for the SOC of the target battery pack 30 from the battery data retaining unit 121 (S10).

The running status estimation unit 113 calculates the average amount of SOC change by dividing the SOC consumption during the power-on period by the power-on duration during a single period of use (S11). The running status estimation unit 113 calculates the amount of SOC change since the point of time one unit before by subtracting the SOC at the point of time one unit before from the SOC at the target point of time (S12).

The running status estimation unit 113 calculates the amount of running SOC change since the point of time one unit before reflecting the change in the estimated speed level by subtracting, from the amount of SOC change since the point of time one unit before, the amount of non-running SOC change per unit time and the amount of running SOC change since the point of time one unit before identified by assuming that the estimated speed level of the electric motorcycle 40 at the point of time one unit before is maintained (S13).

The running status estimation unit 113 calculates the estimated speed level at the target point of time based on the amount of running SOC change since the point of time one unit before reflecting the change in the estimated speed level and the estimated speed level at the point of time one unit before (S14). The SOC transition identification unit 112 increments the target point of time (S15). When the process for the SOC data at all points of time is not completed (N in S16), the process makes a transition to step S12, whereupon steps S12-step S15 are repeated. When the process for the SOC data at all points of time is completed (Y in S16), the generation of the transition of the estimated speed level during a single period of use of the electric motorcycle 40 is completed.

As described above, according to the embodiment, log data stored in the battery pack 30 while the electric motorcycle 40 is running is collected during charging, and the estimated speed level is calculated from the time series data for the SOC. This makes it possible to estimate the status of the electric motorcycle 40 run by the user even if vehicle data such as speed and mileage cannot be collected. Specifically, it is easy to know the status of usage by the user (e.g., the ratio between stopping and running during a period of use, frequency of starting/stopping, degree of vehicle speed at a particular point of time or at a particular position of running, proportion of the constant speed running during the period of use) from the degree of change and the magnitude of the estimated speed level. The vehicle usage status estimation method according to the embodiment is particularly effective for electric vehicles of a simple system in which the battery pack 30 cannot receive vehicle data from the vehicle.

Given above is a description of the present disclosure based on the embodiment. The embodiment is intended to be illustrative only and it will be understood by those skilled in the art that various modifications to combinations of constituting elements and processes are possible and that such modifications are also within the scope of the present disclosure.

In the above embodiment, a removable portable/replaceable battery pack 30 is mounted for use on the mounting slot of the electric motorcycle 40. The battery pack 30 may be fixed to the electric motorcycle 40. In this case, the charging apparatus 20 and the battery pack 30 are connected by a charging cable to charge the battery pack 30. The battery data stored in the battery pack 30 is transmitted to the charging apparatus 20 via the charging cable. In the case the battery pack 30 is fixed to the electric motorcycle 40, the vehicle specification information of the electric motorcycle 40 is identified so that highly precise constants m, n, k, and I can be derived.

As described above, the electric motorcycle 40 is an example of an electric vehicle, and the vehicle usage status estimation system 10 according to the embodiment can also be applied to estimation of the usage status of other electric vehicles such as electric bicycles, electric kick skaters, EVs, and ultra-small EVs.

In the above embodiment, an example of acquiring battery data from the battery pack 30 via the charging apparatus 20 has been described. It is also possible to acquire battery data from the battery pack 30 via a data reader having only a communication function and not having a charging function.

The embodiment may be defined by the following items.

[Item 1]

A vehicle usage status estimation system (10) including:

a data acquisition unit (111) that acquires, while a battery pack (30) currently or previously mounted on an electric vehicle (40) is connected to a charging apparatus, time-series battery data covering a period during which the electric vehicle (40) is used from the battery pack (30) via the charging apparatus (20);

an SOC transition identification unit (112) that identifies a transition of SOC (State Of Charge) of the battery pack (30) since completion of previous charging of the battery pack (30) used in the electric vehicle (40), based on the time-series battery data; and

a running status estimation unit (113) that estimates a running status at a time of use of the electric vehicle (40) by referring to the transition of SOC.

According to the system, it is possible to estimate the status of usage of the electric vehicle (40) by the user without using vehicle data.

[Item 2]

The vehicle usage status estimation system (10) according to Item 1,
wherein the running status estimation unit (113):

calculates, by subtracting, from an amount of SOC change since a point of time one unit before, an amount of non-running SOC change per unit time used for an end other than a rotational energy of a running motor of the electric vehicle (40) and an amount of running SOC change used for the rotational energy of the running motor of the electric vehicle (40) since the point of time one unit before identified by assuming that an estimated speed level of the electric vehicle (40) at the point of time one unit before is maintained, the amount of running SOC change since the point of time one unit before reflecting a change in the estimated speed level, and

generates a transition of the estimated speed level at the time of use of the electric vehicle (40) by calculating the estimated speed level at a target point of time based on the amount of running SOC change since the point of time one unit before reflecting the change in the estimated speed level and on the estimated speed level at the point of time one unit before.

According to this system, it is possible to estimate the transition of the speed level of the electric vehicle (40) based on the amount of running SOC change.

[Item 3]

The vehicle usage status estimation system (10) according to Item 2,

wherein the running status estimation unit (113) calculates, based on a transition of the estimated speed level, at least one of a ratio between a running period and a stop period, frequency of starting/stopping, proportion of a constant speed running period, or a speed level with reference to a point of time or a mileage during a period of use of the electric vehicle (40).

According to the system, it is possible to evaluate the status of usage of the electric vehicle (40) by the user specifically.

[Item 4]

The vehicle usage status estimation system (10) according to Item 2 or 3,
wherein the running status estimation unit (113) calculates the estimated speed level as an actual speed by using specification information on the electric vehicle (40).

According to this system, it is possible to estimate the transition of the actual speed of the electric vehicle (40) based on the amount of running SOC change.

[Item 5]

A vehicle usage status estimation method including:

acquiring, while a battery pack (30) currently or previously mounted on an electric vehicle (40) is connected to a charging apparatus (20), time-series battery data covering a period during which the electric vehicle (40) is used from the battery pack (30) via the charging apparatus (20);
identifying a transition of SOC of the battery pack (30) since completion of previous charging of the battery pack (30) used in the electric vehicle (40), based on the time-series battery data; and
estimating a running status at a time of use of the electric vehicle (40) by referring to the transition of SOC.

According to the method, it is possible to estimate the status of usage of the electric vehicle (40) by the user without using vehicle data.

[Item 6]

A vehicle usage status estimation program including computer-implemented modules including:

a module that acquires, while a battery pack (30) currently or previously mounted on an electric vehicle (40) is connected to a charging apparatus (20), time-series battery data covering a period during which the electric vehicle (40) is used from the battery pack (30) via the charging apparatus (20);
a module that identifies a transition of SOC of the battery pack (30) since completion of previous charging of the battery pack (30) used in the electric vehicle (40), based on the time-series battery data; and
a module that estimates a running status at a time of use of the electric vehicle (40) by referring to the transition of SOC.

According to the program, it is possible to estimate the status of usage of the electric vehicle (40) by the user without using vehicle data.

INDUSTRIAL APPLICABILITY

The present disclosure is applicable to an electric vehicle equipped with a battery pack.

REFERENCE SIGNS LIST

2 commercial power system, 5 network, 10 vehicle usage status estimation system, 11 control unit, 111 data acquisition unit, 112 SOC transition identification unit, 113 running status estimation unit, 12 storage unit, 121 battery data retaining unit, 13 communication unit, 20 charging apparatus, 21 charging table, SLc1-SLc8 charging slot, 22 control unit, 23 charging unit, 24 display unit, 25 user operation unit, 26 communication unit, 30 battery pack, 31 battery assembly, 32 battery control unit, 33 processing unit, 34 storage unit, 35 voltage measurement unit, 36 current sensor, 37 temperature sensor, 40 electric motorcycle, E1-En cell, RY1 relay

**Claims**

1. A vehicle usage status estimation system comprising:

a data acquisition unit that acquires, while a battery pack currently or previously mounted on an electric vehicle is connected to a charging apparatus, time-series battery data covering a period during which the electric vehicle is used from the battery pack via the charging apparatus;

an SOC transition identification unit that identifies a transition of SOC (State Of Charge) of the battery pack since completion of previous charging of the battery pack used in the electric vehicle, based on the time-series battery data; and

a running status estimation unit that estimates a running status at a time of use of the electric vehicle by referring to the transition of SOC.

2. The vehicle usage status estimation system according to Claim 1, wherein the running status estimation unit:

calculates, by subtracting, from an amount of SOC change since a point of time one unit before, an amount of non-running SOC change per unit time used for an end other than a rotational energy of a running motor of the electric vehicle and an amount of running SOC change used for the rotational energy of the running motor of the electric vehicle since the point of time one unit before identified by assuming that an estimated speed level of the electric vehicle at the point of time one unit before is maintained, the amount of running SOC change since the point of time one unit before reflecting a change in the estimated speed level, and

generates a transition of the estimated speed level at the time of use of the electric vehicle by calculating the estimated speed level at a target point of time based on the amount of running SOC change since the point of time one unit before reflecting the change in the estimated speed level and on the estimated speed level at the point of time one unit before.

3. The vehicle usage status estimation system according to Claim 2, wherein the running status estimation unit calculates, based on a transition of the estimated speed level, at least one of a ratio between a running period and a stop period, frequency of starting/stopping, proportion of a constant speed running period, or a speed level with reference to a point of time or a mileage during a period of use of the electric vehicle.

4. The vehicle usage status estimation system according to Claim 2 or 3, wherein the running status estimation unit calculates the estimated speed level as an actual speed by using specification information on the electric vehicle.

5. A vehicle usage status estimation method comprising:

acquiring, while a battery pack currently or previously mounted on an electric vehicle is connected to a charging apparatus, time-series battery data covering a period during which the electric vehicle is used from the battery pack via the charging apparatus;

identifying a transition of SOC (State Of Charge) of the battery pack since completion of previous charging of the battery pack used in the electric vehicle, based on the time-series battery data; and

estimating a running status at a time of use of the electric vehicle by referring to the transition of SOC.

6. A vehicle usage status estimation program comprising computer-implemented modules including:

a module that acquires, while a battery pack currently or previously mounted on an electric vehicle is connected to a charging apparatus, time-series battery data covering a period during which the electric vehicle is used from the battery pack via the charging apparatus;

a module that identifies a transition of SOC (State Of Charge) of the battery pack since completion of previous charging of the battery pack used in the electric vehicle, based on the time-series battery data; and

a module that estimates a running status at a time of use of the electric vehicle by referring to the transition of SOC.

FIG. 1

FIG. 2

FIG. 3

# FIG. 4

COMMUNICATION UNIT — 13

DATA ACQUISITION UNIT — 111

SOC TRANSITION IDENTIFICATION UNIT — 112

RUNNING STATUS ESTIMATION UNIT — 113

PROCESSING UNIT — 11

BATTERY DATA RETAINING UNIT — 121

STORAGE UNIT — 12

VEHICLE USAGE STATUS ESTIMATION SYSTEM — 10

FIG. 5

EP 4 657 701 A1

FIG. 6

EP 4 657 701 A1

FIG. 7

FIG. 8

FIG. 9

EP 4 657 701 A1

## FIG. 10

START

S10 READ TIME-SERIES DATA FOR SOC OF BATTERY PACK

S11 CALCULATE AVERAGE AMOUNT OF SOC CHANGE BY DIVIDING SOC CONSUMPTION DURING POWER-ON PERIOD BY POWER-ON DURATION

S12 CALCULATE AMOUNT OF SOC CHANGE PER UNIT TIME BY SUBTRACTING SOC AT POINT OF TIME ONE UNIT BEFORE FROM SOC AT TARGET POINT OF TIME

S13 CALCULATE AMOUNT OF RUNNING SOC CHANGE REFLECTING SPEED CHANGE BY SUBTRACTING, FROM AMOUNT OF SOC CHANGE, AMOUNT OF NON-RUNNING SOC CHANGE AND AMOUNT OF RUNNING SOC IDENTIFIED BY ASSUMING SPEED LEVEL

S14 CALCULATE ESTIMATED SPEED LEVEL AT TARGET POINT OF TIME BASED ON AMOUNT OF RUNNING SOC CHANGE REFLECTING SPEED CHANGE AND ESTIMATED SPEED LEVEL AT POINT OF TIME ONE UNIT BEFORE

S15 INCREMENT TARGET POINT OF TIME

S16 END OF SOC DATA? — N / Y

END

# EP 4 657 701 A1

## INTERNATIONAL SEARCH REPORT

| International application No. |
|---|
| **PCT/JP2023/030486** |

### A. CLASSIFICATION OF SUBJECT MATTER

*H02J 7/00*(2006.01)i; *G01R 31/3828*(2019.01)i; *G07F 17/00*(2006.01)i; *H01M 10/48*(2006.01)i
FI:  H02J7/00 P; H01M10/48 P; G01R31/3828; G07F17/00 Z

According to International Patent Classification (IPC) or to both national classification and IPC

### B. FIELDS SEARCHED

Minimum documentation searched (classification system followed by classification symbols)

H02J7/00; G01R31/3828; G07F17/00; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/027119 A1 (HONDA MOTOR CO., LTD.) 06 February 2020 (2020-02-06) paragraphs [0031]-[0061], fig. 1-4 | 1, 5-6 |
| A | | 2-4 |
| A | JP 2019-114450 A (TOYOTA JIDOSHA KABUSHIKI KAISHA) 11 July 2019 (2019-07-11) entire text, all drawings | 1-6 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 October 2023** | **24 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/030486**

| Patent document cited in search report | Publication date (day/month/year) | Patent family member(s) | Publication date (day/month/year) |
|---|---|---|---|
| WO 2020/027119 A1 | 06 February 2020 | (Family: none) | |
| JP 2019-114450 A | 11 July 2019 | US 2019/0195953 A1 entire text, all drawings CN 109962303 A | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018035677 A

- JP 2021051843 A